# EUROPÄISCHE PATENTSCHRIFT

(11) **EP 1 366 522 B1**
(45) Veröffentlichungstag und Bekanntmachung des Hinweises auf die Patenterteilung: **12.11.2008**
(21) Anmeldenummer: 02717985.2
(22) Anmeldetag: 01.03.2002
(51) Int. Cl.: H01L 23/522, H01L 21/768

(54) **VERFAHREN ZUR HERSTELLUNG EINER LEITERBAHNANORDNUNG AUF EINER INTEGRIERTEN SCHALTUNGSANORDNUNG**
METHOD OF PRODUCING INTERCONNECTS ON AN INTEGRATED CIRCUIT
PROCÉDÉ DE FABRICATION D'INTERCONNEXIONS DANS UN CIRCUIT INTEGRÉ

(30) Priorität: 01.03.2001 DE 10109877
(43) Veröffentlichungstag der Anmeldung: 03.12.2003
(73) Patentinhaber: Infineon Technologies AG, 81669 München (DE)
(72) Erfinder: ENGELHARDT, Manfred, 83620 Feldkirchen-Westerham (DE); SCHINDLER, Guenther, 80802 München (DE)
(74) Vertreter: Viering, Jentschura & Partner
(86) Internationale Anmeldenummer: PCT/DE2002/000758
(87) Internationale Veröffentlichungsnummer: WO 2002/071483

(56) Entgegenhaltungen:
- EP-A- 0 687 004
- US-A- 5 759 913
- US-A- 6 130 151
- PATENT ABSTRACTS OF JAPAN vol. 1998, no. 10, 31. August 1998 (1998-08-31) -& JP 10 116903 A (NIPPON STEEL CORP), 6. Mai 1998 (1998-05-06)

## Beschreibung

Die Erfindung betrifft ein Verfahren zur Herstellung einer Leiterbahnanordnung.

Integrierte Schaltungsanordnungen werden mit immer höherer Packungsdichte erzeugt. Dies hat zur Folge, dass Leiterbahnen in Metallisierungsebenen einen immer kleineren Abstand voneinander aufweisen. Dadurch steigen Kapazitäten, die zwischen den Leiterbahnen gebildet werden und zu hohen Signallaufzeiten, hoher Verlustleistung und Übersprechen führen. Bisher wurde zur Isolation zwischen den Leiterbahnen hauptsächlich SiO₂ als Dielektrikum verwendet, dessen relative Dielektrizitätskonstante εᵣ = 3,9 beträgt.

Es sind einige Methoden zur Erniedrigung der relativen Dielektrizitätskonstante εᵣ und damit zur Erniedrigung der Kapazität zwischen Leiterbahnen innerhalb einer Leiterbahnebene bekannt, beispielsweise aus [1], [2] oder [3].

Gemäß dem zitierten Stand der Technik werden Hohlräume zwischen den Leiterbahnen innerhalb einer Leiterbahnebene erzeugt. Das isolierende Dielektrikum, das die Kapazität zwischen den Leiterbahnen bestimmt, weist somit eine relative Dielektrizitätskonstante εᵣ auf, die fast gleich Eins ist. Die Leiterbahnen selbst sind dabei zur Isolation oben und unten von massiven SiO₂-Schichten eingeschlossen.

Da zur Gesamtkapazität zwischen innerhalb einer Schicht benachbarten Leiterbahnen auch in nicht unerheblichem Maße die Kapazitäten der darunter und darüber liegenden isolierenden Schichten beitragen und diese isolierenden Schichten nach wie vor aus SiO₂-Vollmaterial bestehen, hat die hohe relative Dielektrizitätskonstante εᵣ dieser isolierenden Schichten einen beträchtlichen Einfluss auf die Gesamtkapazität zwischen den benachbarten Leiterbahnen.

Bei der verwendung eines low-k-Materials für die isolierende Schicht über den Leiterbahnen werden wegen der geringen Viskosität des low-k-Materials die Hohlräume zwischen benachbarten Leiterbahnen wieder gefüllt. Damit ergibt sich wieder eine hohe relative Dielektrizitätskonstante εᵣ und somit eine hohe Gesamtkapazität zwischen benachbarten Leiterbahnen.

Aus [4] ist ein Verfahren zum Herstellen einer Leiterbahnanordnung bekannt, bei dem über nebeneinander angeordneten Leiterbahnen unter Verwenden eines die Zwischenräume zwischen den nebeneinander angeordneten Leiterbahnen füllenden Spacermaterials ein Isolationsfilm aufgebracht wird, bei dem dann in dem Isolationsfilm kleine Durchgangslöcher, sogenannte "pin holes", unter Verwenden eines Lithographie- und Ätzverfahrens ausgebildet werden und bei dem dann das Spacermaterial mittels Ätzens durch die kleinen Durchgangslöcher hindurch wieder entfernt wird. Wird daraufhin eine Isolationsschicht auf dem Isolationsfilm aufgebracht, ermöglicht der Isolationsfilm mit den kleinen Durchgangslöchern das Ausbilden eines Hohlraums zwischen jeweils zwei benachbarten Leiterbahnen.

Ein Verfahren zum Erzeugen eines Hohlraums zwischen zwei Leiterbahnen ist auch aus [5] bekannt, bei dem zwischen zwei auf einem Substrat angeordneten, benachbarten Leiterbahnen eine Isolationsschicht und über den Leiterbahnen und der Isolationsschicht eine Ätzstoppschicht aufgebracht werden, bei dem in die Ätzstoppschicht mittels eines Lithographie- und Ätzverfahrens eine Durchgangsöffnung im Bereich zwischen den zwei Leiterbahnen erzeugt wird, bei dem die Isolationsschicht durch die Durchgangsöffnung hindurch isotrop geätzt wird, bis ein Teil des Substrats freigelegt ist, und bei dem dann über der Ätzstoppschicht eine isolierende Deckschicht aufgebracht wird, wobei sich auf Grund der isotrop geätzten Isolationsschicht zwischen den benachbarten Leiterbahnen ein Hohlraum ausbildet.

Aus [6] und [7] sind des weiteren Leiterbahnanordnungen bekannt, bei denen kombinierte Isolations-Ätzstoppschichten bzw. im Substrat unter der Leiterbahnanordnung bereits vorhandene Leiterbahnen verwendet werden.

Der Erfindung liegt somit das Problem zugrunde, eine Leiterbahnanordnung sowie ein Verfahren zur Herstellung einer Leiterbahnanordnung anzugeben, bei der/dem die Hohlräume zwischen den Leiterbahnen unabhängig vom verwendeten Material für die isolierende Schicht, welche die Leiterbahnen überdeckt, einen möglichst großen Raum einnehmen und somit zwischen den Leiterbahnen eine möglichst kleine Kapazität auf Grund einer kleinen relativen Dielektrizitätskonstante εᵣ erreicht wird, wobei die Herstellung der Hohlräume gegenüber dem Stand der Technik vereinfacht ist.

Das Problem wird durch ein Verfahren zur Herstellung einer Leiterbahnanordnung mit den Merkmalen gemäß dem unabhängigen Anspruch 1 gelöst.

Ein Vorteil der Erfindung ist darin zu sehen, dass mittels der möglichst großen Hohlräume als isolierende Schicht zwischen benachbarten Leiterbahnen die relative Dielektrizitätskonstante εᵣ der isolierenden Schicht zwischen den benachbarten Leiterbahnen nur gering von Eins abweicht und somit die Kapazität zwischen diesen Leiterbahnen reduziert wird. Die Leiterbahnanordnung ermöglicht eine erhebliche Reduzierung der Gesamtkapazität innerhalb einer integrierten Schaltung. Auf Grund von Streufeldern oberhalb und unterhalb der Leiterbahnanordnung beträgt die effektive relative Dielektrizitätskonstante εᵣ für die gesamte Leiterbahnanordnung in etwa Zwei. Dabei ist der Wert der effektiven relativen Dielektrizitätskonstante εᵣ von der Geometrie der gesamten Leiterbahnanordnung abhängig.

Ein weiterer Vorteil der Erfindung ist, dass die Hohlräume zwischen den Leiterbahnen nicht mittels einer selektiven Abscheidung einer die Hohlräume überdeckenden Schicht aus isolierendem Material hergestellt werden müssen. Somit ist für solch einen selektiven Abscheidungsprozess auch keine zeitaufwändige Prozessoptimierung erforderlich. Vor allem wird auf Grund der Erfindung die Bildung von Menisken aus dem isolierenden Material im Bereich der Hohlräume vermieden.

Vorzugsweise befindet sich zwischen der ersten Schicht, den benachbarten Leiterbahnen, den zweiten Schichten und der dritten Schicht ein Hohlraum, welcher elektrisch isolierend zwischen den benachbarten Leiterbahnen wirkt. Dieser Hohlraum, in dem nach Fertigstellung der Leiterbahnanordnung Luft, Vakuum oder ein isolierendes Gas, beispielsweise Schwefelhexafluorid (SF₆), vorliegt, weist somit eine relative Dielektrizitätskonstante εᵣ von fast gleich Eins auf. Somit ist die Kapazitätswirkung der Leiterbahnanordnung gering.

In einer bevorzugten Weiterbildung der Erfindung befindet sich zwischen der ersten Schicht und den Leiterbahnen mindestens eine Zwischenschicht aus einem zweiten Material. Diese Zwischenschicht kann beispielsweise dazu vorgesehen sein, während der Herstellung der Leiterbahnanordnung eine Barriere für notwendige Ätzprozesse bereitzustellen, damit die erste Schicht, meist Siliziumdioxid (SiO₂) aufweisend, nicht beschädigt wird.

Vorzugsweise ist das dritte Isolationsmaterial ein low-k-Material, das eine relative Dielektrizitätskonstante εᵣ im Bereich zwischen 1 und 4 hat. Da auch die dritte Schicht, welche die Leiterbahnanordnung vollständig überdeckt und in vertikaler Richtung zur ersten Schichtoberfläche isolierend abschirmt, einen Beitrag zur Gesamtkapazität zwischen benachbarten Leiterbahnen liefert, sollte darauf geachtet werden, dass auch das für die dritte Schicht verwendete dritte Isolationsmaterial eine niedrige relative Dielektrizitätskonstante εᵣ aufweist.

In einer bevorzugten Weiterbildung ist das dritte Isolationsmaterial ein low-k-Material, das eine relative Dielektrizitätskonstante εᵣ im Bereich zwischen 1,5 und 3 hat.

Das zweite Isolationsmaterial und/oder das dritte Isolationsmaterial der Leiterbahnanordnung weisen bevorzugt Siliziumdioxid (SiO₂) auf. Alternativ können das zweite Isolationsmaterial und/oder das dritte Isolationsmaterial auch Siliziumnitrid (Si₃N₄) oder ein organisches Material aufweisen. Weiterhin kann als zweites Isolationsmaterial und/oder als drittes Isolationsmaterial auch ein auf Silizium basierendes Oxydnitrid verwendet werden. Um bei der Verwendung dieser Isolationsmaterialien eine niedrige relative Dielektrizitätskonstante εᵣ zu erzielen, sollte das jeweilige Isolationsmaterial in poröser Form aufgebracht werden. Bei der Verwendung von organischem Material werden bevorzugt Polymere in einer Methan-Umgebung während eines PECVD-Prozesses (PECVD = plasma enhanced chemical vapor deposition = plasmaangeregte chemische Gasphasenabscheidung) aufgebracht.

In einem Beispiel einer Leiterbahnanordnung weist die erste Schicht mindestens zwei übereinander angeordnete Teilschichten auf. Die obere Teilschicht ist entsprechend den Bereichen zwischen den Leiterbahnen derart strukturiert, dass die obere Teilschicht unter den Leiterbahnen angeordnet ist und unter den Bereichen zwischen den Leiterbahnen zumindest teilweise fehlt. Zwischen benachbarten Leiterbahnen werden somit Gräben in der isolierenden ersten Schicht gebildet. Diese Anordnung hat den Vorteil, dass die Leiterbahnen nicht direkt auf einer Isolationsschicht aufgebracht sind, welche die Leiterbahnen auf kürzestem Wege verbindet. Eine die Leiterbahnen auf kürzestem Wege verbindende Isolationsschicht begünstigt elektrische Streufelder zwischen benachbarten Leiterbahnen. Daraus resultiert ein unbefriedigender Wert für die effektive relative Dielektrizitätskonstante εᵣ und somit für die Gesamtkapazität zwischen benachbarten Leiterbahnen. Mittels einer strukturierten oberen Teilschicht kann der Verbindungsweg zwischen benachbarten Leiterbahnen vergrößert und somit die effektive relative Dielektrizitätskonstante εᵣ weiter reduziert werden. Eine strukturierte obere Teilschicht ermöglicht somit eine weitere Reduzierung der Gesamtkapazität zwischen benachbarten Leiterbahnen.

Wenn die beiden Teilschichten das gleiche Isolationsmaterial aufweisen, befindet sich zwischen der oberen Teilschicht und der unteren Teilschicht vorzugsweise eine Ätzstoppschicht aus einem dritten Material. Das dritte Material ist dabei bevorzugt im Wesentlichen resistent gegen auf das erste Isolationsmaterial einwirkende Ätzmittel. Somit lässt sich die Strukturierung der oberen Teilschicht durch Ätzung der oberen Teilschicht mit den Leiterbahnen als Maske herstellen. Die Ätzung wird beendet, wenn die Ätzstoppschicht unter den Bereichen zwischen benachbarten Leiterbahnen freigelegt ist.

Mittels der Dicke der oberen Teilschicht lässt sich somit die Tiefe der Gräben zwischen benachbarten Leiterbahnen einstellen.

Bei einem Verfahren zur Herstellung einer Leiterbahnanordnung wird vor dem Aufbringen der Leiterbahnen auf der ersten Schichtoberfläche bevorzugt mindestens eine Zwischenschicht aus einem zweiten Material auf der ersten Schichtoberfläche erzeugt. Die Zwischenschicht ist als Barriere für Ätzprozesse während der Herstellung der Leiterbahnanordnung vorgesehen, damit die erste Schicht, meist Siliziumdioxid (SiO₂) aufweisend, nicht beschädigt wird. Wird als erstes Isolationsmaterial für die erste Schicht eine Sauerstoff-Verbindung gewählt, so wird als zweites Material für die Zwischenschicht vorzugsweise eine Stickstoff-Verbindung, beispielsweise eine Titan-Stickstoff-Verbindung, verwendet. Wird eine Titan-Stickstoff-Verbindung verwendet, muss die Zwischenschicht noch auf Bereichen der ersten Schichtoberfläche, welche nicht durch die Leiterbahnen bedeckt werden, entfernt werden. Dies wird meistens mittels eines Ätzprozesses erreicht, wobei die Leiterbahnen als Maske für die Zwischenschicht dienen. Bei einer Verwendung einer Stickstoff-Verbindung als erstes Isolationsmaterial für die erste Schicht wird als zweites Material für die Zwischenschicht eine Sauerstoff-Verbindung bevorzugt. Wird für die Zwischenschicht sowie für die im Folgenden hergestellten Spacer das gleiche Material verwendet, so ist direkt über der Zwischenschicht vorzugsweise eine dünne, weitere Zwischenschicht aus einem anderen Material vorgesehen.

Vorzugsweise werden zwischen benachbarten Leiterbahnen Gräben erzeugt, welche zumindest teilweise in die erste Schicht hineinreichen. Somit wird der Verbindungsweg zwischen benachbarten Leiterbahnen verlängert und die Entstehung von die Gesamtkapazität beeinträchtigenden elektrischen Streufeldern reduziert.

Die erste Schicht wird bevorzugt aus einer oberen Teilschicht, einer Ätzstoppschicht und einer unteren Teilschicht erzeugt. Die Gräben zwischen benachbarten Leiterbahnen werden dann dadurch erzeugt, dass mittels der Leiterbahnen als Maske die obere Teilschicht unter den Bereichen zwischen benachbarten Leiterbahnen entfernt wird. Dabei wird die Ätzstoppschicht freigelegt. Wird als erstes Isolationsmaterial für die erste Schicht und somit für die obere Teilschicht sowie für die untere Teilschicht Siliziumdioxid (SiO₂) gewählt, dann kann für die Ätzstoppschicht beispielsweise Siliziumnitrid (Si₃N₄) verwendet werden.

Die Spacer dienen als Hilfsstützen für die Herstellung der zweiten Schichten, welche über die Leiterbahnen überstehen. Als Spacermaterial wird bevorzugt Siliziumnitrid (Si₃N₄), verwendet, welches an den Seitenwänden der Leiterbahnen konform aufgebracht wird. Alternativ kann auch ein anderes Spacermaterial verwendet werden, welches konform aufgebracht und selektiv zu den zweiten Schichten sowie zu der ersten Schicht geätzt werden kann.

Die Spacer werden in einer bevorzugten Ausführungsform des erfindungsgemäßen Verfahrens auf den Seitenwänden der Leiterbahnen mittels einer konformen Abscheidung von Spacermaterial sowie einer selektiven und anisotropen Ätzung des Spacermaterials erzeugt. Zunächst wird über den Leiterbahnen und über Bereichen der ersten Schichtoberfläche, welche nicht durch die Leiterbahnen bedeckt werden, Spacermaterial konform abgeschieden. Anschließend wird das Spacermaterial parallel zur zweiten Schichtoberfläche selektiv und anisotrop geätzt. Somit ist eine gezielte Herstellung sowie eine Einstellung der Form der Spacer möglich. Die Dicke des abgeschiedenen Spacermaterials wird bevorzugt derart eingestellt, dass die verbleibende Lücke zwischen zwei benachbarten Leiterbahnen gerade noch nicht geschlossen ist. Zwischen den benachbarten Leiterbahnen bzw. den an deren Seitenwänden befindlichen Spacer bleibt somit ein dünner Luftspalt übrig.

Bei dem erfindungsgemäßen Verfahren werden die Spacer unter den zweiten Schichten vorzugsweise wieder entfernt. Da die Spacer nur als Hilfsstützen für die Herstellung der zweiten Schichten dienen und eine Bildung von möglichst großen. Hohlräumen zwischen den Leiterbahnen behindern würden, werden die Spacer nach der Herstellung der zweiten Schichten wieder entfernt.

Vorzugsweise werden die zweiten Schichten mittels eines nicht-konformen Verfahrens im Wesentlichen parallel zur ersten Schichtoberfläche über der zweiten Schichtoberfläche und den Spacern erzeugt. Dazu wird das zweite Isolationsmaterial der zweiten Schichten mittels eines CVD-Prozesses (CVD = chemical vapor deposition = chemische Gasphasenabscheidung) mit möglichst geringer Kantenbedeckung hauptsächlich auf den um die Spacer verbreiterten Leiterbahnen abgeschieden. Dazu wird der CVD-Prozess im diffusionsbeatimmten Regime, vorzugsweise mittels Druckerhöhung, betrieben. Statt mittels eines CVD-Prozesses kann das zweite Isolationsmaterial zur Herstellung der zweiten Schichten auch mittels eines Sputter-Prozesses hergestellt werden. Ein möglicherweise tief in die Luftspalte eingedrungenes zweites Isolationsmaterial kann mit Hilfe einer kurzen isotropen Ätzung, beispielsweise nasschemisch oder auch trocken in einem Downstream-Ätzprozess, wieder entfernt werden. Ein solcher Downstream-Ätzprozess ist in [8] beschrieben.

In einer bevorzugten Ausführungsform des erfindungsgemäßen Verfahrens wird das Spacermaterial der Spacer nach der Erzeugung der zweiten Schichten weggeätzt, wobei ein selektiver Ätzprozess zur Anwendung kommt. Der selektive Ätzprozess ist dabei vorzugsweise isotrop. Der zwischen benachbarten Spacern befindliche Luftspalt ist dabei zur Entfernung der Spacer notwendig, um dem Ätzmittel an den Spacern eine Angriffsfläche zu bieten. Mögliche Ätzprozesse sind beispielsweise ein nasschemischer Ätzprozess oder ein in [9] für Siliziumdioxid (SiO₂) beschriebener Downstream-Trockenätzprozess mit hoher Selektivität.

Die Erzeugung der dritten Schicht erfolgt bevorzugt derart, dass zunächst drittes Isolationsmaterial mittels eines nicht-konformen Verfahrens über den zweiten Schichten abgeschieden wird, bis sich Hohlräume zwischen der ersten Schicht, den benachbarten Leiterbahnen, den zweiten Schichten und der dritten Schicht gebildet haben. Anschließend wird drittes Isolationsmaterial mittels eines konformen Standardverfahrens abgeschieden. Während des nicht-konformen Verfahrens dringt wegen der schirmartig wirkenden zweiten Schichten kaum drittes Isolationsmaterial in die entstehenden Hohlräume ein. Dadurch kommt es zu einer nur sehr geringen Bedeckung der Seitenwände der Leiterbahnen mit drittem Isolationsmaterial, wodurch die relative Dielektrizitätskonstante εᵣ der gesamten Leiterbahnanordnung nur unwesentlich beeinflusst wird. Bei kleineren Strukturgrößen wie beispielsweise einer hochintegrierten Schaltung (VLSI-Schaltung = very large scale integration) kann keine Bedeckung der Seitenwände der Leiterbahnen mit drittem Isolationsmaterial mehr festgestellt werden.

Ausführungsbeispiele der Erfindung sind in den Figuren dargestellt und werden im folgenden näher erläutert. Dabei bezeichnen gleiche Bezugszeichen gleiche Komponente.

Es zeigen
- Figur 1: einen Querschnitt durch eine Leiterbahnanordnung;
- Figur 2: einen Querschnitt durch eine noch nicht fertiggestellte Leiterbahnanordnung gemäß Fig.1 zu einem ersten Zeitpunkt während der Durchführung des Herstellungsverfahrens gemäß dem ersten Ausführungsbeispiel der Erfindung;
- Figur 3: einen Querschnitt durch eine noch nicht fertiggestellte Leiterbahnanordnung gemäß Fig.1 zu einem zweiten Zeitpunkt während der Durchführung des Herstellungsverfahrens gemäß dem ersten Ausführungsbeispiel der Erfindung;
- Figur 4: einen Querschnitt durch eine noch nicht fertiggestellte Leiterbahnanordnung gemäß Fig.1 zu einem dritten Zeitpunkt während der Durchführung des Herstellungsverfahrens gemäß dem ersten Ausführungsbeispiel der Erfindung;
- Figur 5: einen Querschnitt durch eine noch nicht fertiggestellte Leiterbahnanordnung gemäß Fig.1 zu einem vierten Zeitpunkt während der Durchführung des Herstellungsverfahrens gemäß dem ersten Ausführungsbeispiel der Erfindung; und
- Figur 6: einen Querschnitt durch eine noch nicht fertiggestellte Leiterbahnanordnung zu einem ersten Zeitpunkt während der Durchführung des Herstellungsverfahrens gemäß einem zweiten Ausführungsbeispiel der Erfindung.

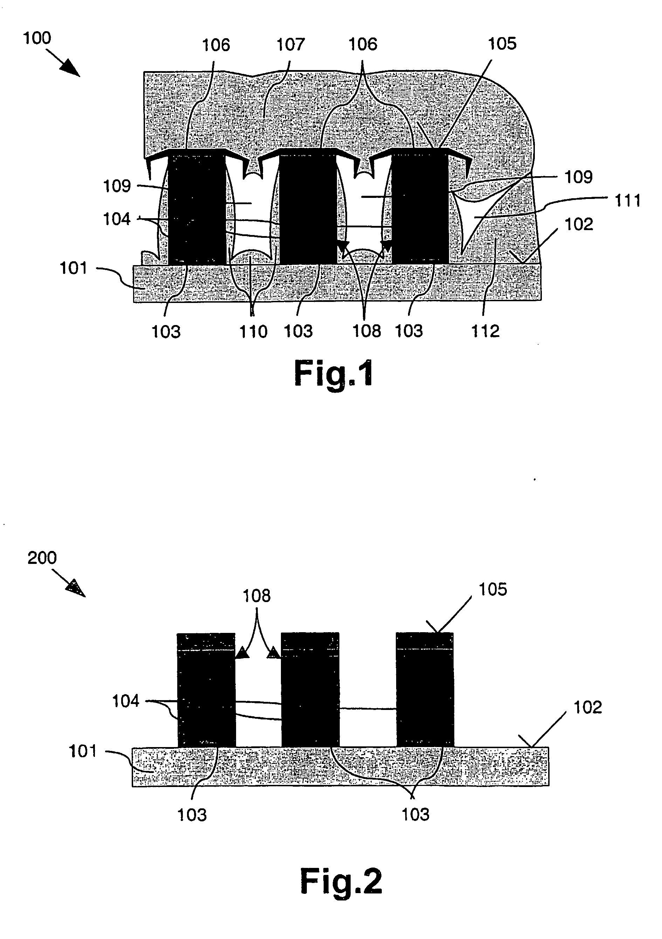

**Fig. 1** zeigt einen Querschnitt durch eine Leiterbahnanordnung 100.

Die Leiterbahnanordnung 100 weist ein Substrat mit einer als erste Schichtoberfläche 102 ausgebildeten Substratoberfläche als erste Schicht 101 auf. Als Substratmaterial wird ein isolierendes Material, gemäß diesem Ausführungsbeispiel Siliziumdioxid (SiO₂), gewählt.

Auf der ersten Schichtoberfläche 102 befinden sich Leiterbahnen 104 aus Aluminium oder Kupfer mit jeweils einer Zwischenschicht 103 aus einer Titan-Stickstoff-Verbindung zwischen der ersten Schichtoberfläche 102 und den Leiterbahnen 104. Die Leiterbahnen 104 werden von einer parallel zur ersten Schichtoberfläche 102 angeordneten zweiten Schichtoberfläche 105 sowie die erste Schichtoberfläche 102 und die zweite Schichtoberfläche 105 verbindenden Seitenwänden 108 begrenzt.

Auf der zweiten Schichtoberfläche 105 einer jeden Leiterbahn 104 befindet sich eine zweite Schicht 106 aus Siliziumdioxid (SiO₂), welche über die jeweilige Leiterbahn 104 übersteht. In diesem Ausführungsbeispiel der Erfindung weisen die zweiten Schichten 106 die Form von die Leiterbahnen 104 bedeckenden Schirmen auf. Die zweiten Schichten 106 überdecken dabei Bereiche zwischen benachbarten Leiterbahnen 104. Da sich die zweiten Schichten 106 benachbarter Leiterbahnen 104 nicht berühren, werden die Bereiche zwischen den benachbarten Leiterbahnen 104 von den zweiten Schichten 106 nicht vollständig abgeschlossen.

Eine dritte Schicht 107 aus Siliziumdioxid (SiO₂) überdeckt die zweiten Schichten 106 und schließt damit die Bereiche zwischen den benachbarten Leiterbahnen 104 vollständig ab. Zwischen benachbarten Leiterbahnen 104 befinden sich somit von der ersten Schichtoberfläche 102, den Seitenwänden 108 der Leiterbahnen 104, den zweiten Schichten 106 und der dritten Schicht 107 eingeschlossene Hohlräume 109.

Während der Herstellung der dritten Schicht 107 konnte Siliziumdioxid (SiO₂) in die nicht vollständig abgeschlossenen Bereiche zwischen den benachbarten Leiterbahnen 104 eindringen. Dadurch wurde eine dünne Bedeckung 110 der Seitenwände 108 der Leiterbahnen 104 sowie des nicht von den Leiterbahnen 104 bedeckten Teils der ersten Schichtoberfläche 102 mit Siliziumdioxid (SiO₂) verursacht. Je kleiner der Abstand benachbarter zweiter Schichten 106 zueinander ist, desto geringer ist die Bedeckung 110 der Seitenwände 108 der Leiterbahnen 104 sowie des nicht von den Leiterbahnen 104 bedeckten Teils der ersten Schichtoberfläche 102. In einem anderen Ausführungsbeispiel der Erfindung (in den Figuren nicht dargestellt) können die zweiten Schichten 106 auch mit einem derart geringen Abstand hergestellt werden, dass keinerlei Bedeckung 110 entsteht.

Am Ende der Leiterbahnanordnung 100 weist die letzte Leiterbahn 104 nur noch auf einer Seite eine benachbarte Leiterbahn 104 auf. Die letzte Leiterbahn 104 benötigt auf der Seite ohne benachbarte Leiterbahn 104 eine elektrische Isolierung gegenüber der Umgebung. Dabei kann auf eine niedrige relative Dielektrizitätskonstante εᵣ mangels eines eine Kapazität darstellenden weiteren elektrisch leitenden Elements verzichtet werden. Somit wird die letzte Leiterbahn 104 nicht mehr mittels eines Hohlraums 109 wie zwischen benachbarten Leiterbahnen 104 sondern mittels eines Abschlusshohlraums 111 und einer Abschlussisolationsschicht 112 elektrisch isoliert.

Der Abstand benachbarter Leiterbahnen 104 sowie die Dicke der Leiterbahnen 104 sollten bevorzugt derart gewählt werden, dass die Leiterbahnanordnung 100 eine ausreichend gute Tragfähigkeit für weitere über der Leiterbahnanordnung 100 angeordnete Schichten und Metallisierungsebenen aufweist. Gemäß diesem Ausführungsbeispiel weisen die Leiterbahnen 104 jeweils eine Breite auf, welche fast gleich dem Abstand benachbarter Leiterbahnen 104 ist. Die Leiterbahnen 104 weisen gemäß diesem Ausführungsbeispiel eine Höhe auf, welche der zweifachen Breite der Leiterbahnen 104 entspricht.

Alternativ können auch andere Maße für die Breite, die Höhe und/oder die Abstände der Leiterbahnen 104 gewählt werden.

Im Folgenden wird schrittweise ein Verfahren zur Bildung der Leiterbahnanordnung 100 gemäß dem ersten Ausführungsbeispiel der Erfindung beschrieben.

In **Fig.2** ist ein Querschnitt durch eine noch nicht fertiggestellte Leiterbahnanordnung 200 zu einem ersten Zeitpunkt während der Durchführung des Herstellungsverfahrens gemäß dem ersten Ausführungsbeispiel der Erfindung gezeigt.

Als erste Schicht 101 wird ein Substrat mit einer als erste Schichtoberfläche 102 ausgebildeten Substratoberfläche verwendet. Das Substratmaterial ist Siliziumdioxid (SiO₂). Auf der ersten Schichtoberfläche 102 wird eine Zwischenschicht 103 aus einer Titan-Stickstoff-Verbindung mittels eines üblichen Standardverfahrens flächig aufgebracht. Die Zwischenschicht 103 dient bei dem Leiterbahnmaterial Aluminium als Haftschicht für die Leiterbahnen 104 auf der ersten Schicht 101 und bei dem Leiterbahnmaterial Kupfer als Barriere gegen Kupfer-Diffusion zum Schutz der ersten Schicht 101. Bei dem Leiterbahnmaterial Kupfer kann die Zwischenschicht 103 auch Tantal oder eine Tantal-Stickstoff-Verbindung aufweisen.

Über der Zwischenschicht 103 werden unter Anwendung bekannter subtraktiver Verfahren mehrere Leiterbahnen 104 aus Aluminium oder Kupfer gebildet. Die Leiterbahnen 104 schließen mit einer zweiten Schichtoberfläche 105 parallel zur ersten Schichtoberfläche 102 ab und weisen die zweite Schichtoberfläche 105 und die erste Schichtoberfläche 102 verbindende Seitenwände 108 auf.

Bei der Herstellung von Leiterbahnen 104 aus Kupfer kann vorzugsweise die sogenannte Damascene-Technik zur Anwendung kommen: Auf der durch die Zwischenschicht 103 bedeckten ersten Schichtoberfläche 102 wird zunächst eine Hilfsschicht aus Siliziumdioxid (SiO₂) flächig aufgebracht. Dabei wird die Dicke dieser Hilfsschicht entsprechend der gewünschten Höhe für die herzustellenden Leiterbahnen 104 eingestellt. In diese Hilfsschicht werden an den Stellen, an denen die Leiterbahnen 104 gebildet werden sollen, mittels üblicher Lithographie- und Ätztechniken Gräben geätzt. Diese Gräben weisen die gewünschte Breite und den gewünschten Abstand zueinander entsprechend den herzustellenden Leiterbahnen 104 auf und reichen bis zur Zwischenschicht 103 hinab.

Über der Hilfsschicht mit den Gräben wird nun mittels üblicher Metallisierungsverfahren eine Barriereschicht beispielsweise aus einer Tantal-Stickstoff-Verbindung und dann Kupfer abgeschieden, wobei die Gräben überfüllt werden. Zur Herstellung der zur ersten Schichtoberfläche 102 parallelen zweiten Schichtoberfläche 105 wird das die Gräben überfüllende Kupfer sowie die Barriereschicht mittels chemisch-mechanischem Polierens flächig abgetragen. Schließlich wird die Hilfsschicht aus Siliziumdioxid (SiO₂) selektiv zu Kupfer mittels Ätzen entfernt, bis die Zwischenschicht 103 erreicht wird. Die Zwischenschicht 103 aus einer Titan-Stickstoff-Verbindung wirkt dabei als Ätzstoppschicht. Übrig bleiben die auf der ersten Schichtoberfläche 102 und der Zwischenschicht 103 gebildeten Leiterbahnen 104.

Zum Herstellungsprozess der Leiterbahnen 104 gehört noch die abschließende Ätzung der Zwischenschicht 103 an all den Stellen, welche nicht von den Leiterbahnen 104 bedeckt werden. Dabei dienen die Leiterbahnen 104 als Maske für die abschließende Ätzung. Dadurch wird zwischen den Leiterbahnen 104 die erste Schichtoberfläche 102 wieder freigelegt. Die Zwischenschicht 103 befindet sich folglich nunmehr ausschließlich zwischen den Leiterbahnen 104 und der ersten Schichtoberfläche 102.

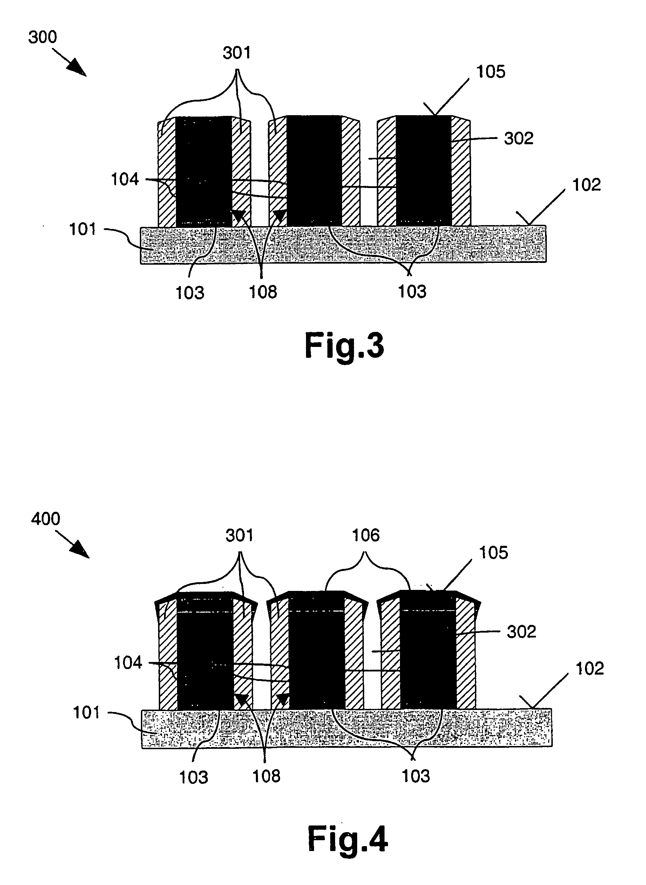

**Fig.3** zeigt einen Querschnitt durch eine noch nicht fertiggestellte Hohlraumstruktur 300 zu einem zweiten Zeitpunkt während der Durchführung des Herstellungsverfahrens gemäß dem ersten Ausführungsbeispiel der Erfindung.

An den Seitenwänden 108 der Leiterbahnen 104 werden Spacer 301 aus Siliziumnitrid (Si₃N₄) konform mittels einer konformen Abscheidung und einer nachfolgenden Ätzung erzeugt, wobei die Spacer 301 derart angeordnet sind, dass sich Spacer 301 benachbarter Leiterbahnen 104 noch nicht berühren. Die Spacer 301 dienen dabei als Hilfsstützen für die nachfolgende Herstellung der zweiten Schichten 106, welche über die Leiterbahnen 104 überstehen.

Die selektive und anisotrope Ätzung des konform abgeschiedenen Spacermaterials ermöglicht eine gezielte Herstellung sowie eine Einstellung der Form der Spacer 301. Die Dicke des abgeschiedenen Spacermaterials wird bevorzugt derart eingestellt, dass die verbleibende Lücke zwischen zwei benachbarten Leiterbahnen 104 gerade noch nicht geschlossen ist. Zwischen den benachbarten Leiterbahnen 104 bzw. den an deren Seitenwänden 108 befindlichen Spacer 301 bleibt somit ein dünner Luftspalt 302 übrig.

In **Fig.4** ist ein Querschnitt durch eine noch nicht fertiggestellte Leiterbahnanordnung 400 zu einem dritten Zeitpunkt während der Durchführung des Herstellungsverfahrens gemäß dem ersten Ausführungsbeispiel der Erfindung gezeigt.

Die zweiten Schichten 106 aus Siliziumdioxid (SiO₂) werden durch ein nicht-konformes Verfahren im Wesentlichen parallel zur ersten Schichtoberfläche 102 über der zweiten Schichtoberfläche 105 und den Spacern 301 erzeugt. Dazu wird das Siliziumdioxid (SiO₂) mittels eines CVD-Prozesses mit möglichst geringer Kantenbedeckung hauptsächlich auf den um die Spacer 301 verbreiterten Leiterbahnen 104 abgeschieden. Dazu wird der CVD-Prozess mittels Druckerhöhung im diffusionsbestimmten Regime betrieben. Durch eine kurze isotrope Ätzung in einem Downstream-Ätzprozess wird möglicherweise tief in die Luftspalte 302 eingedrungenes Siliziumdioxid (SiO₂) wieder entfernt.

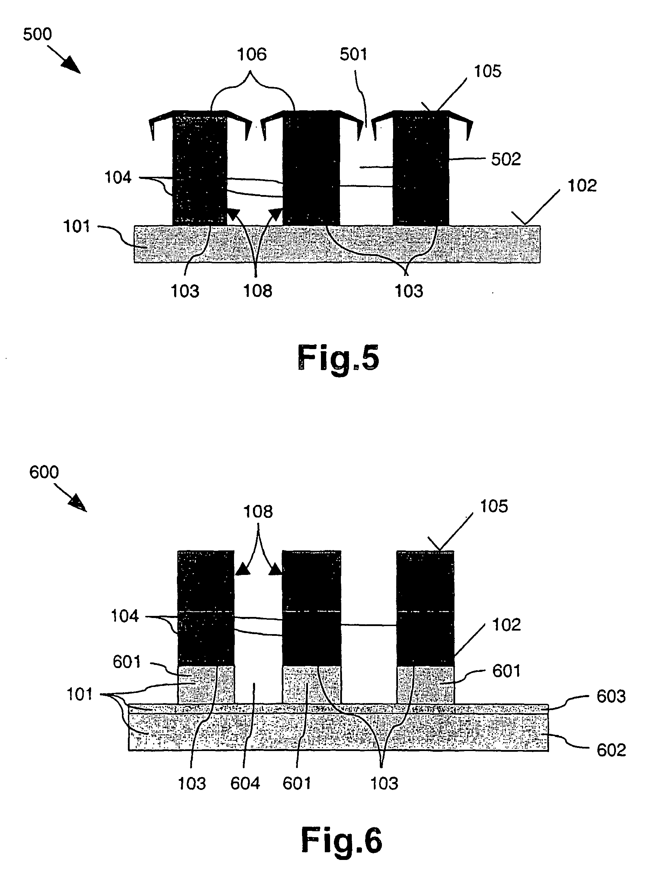

**Fig.5** zeigt einen Querschnitt durch eine noch nicht fertiggestellte Leiterbahnanordnung 500 zu einem vierten Zeitpunkt während der Durchführung des Herstellungsverfahrens gemäß dem ersten Ausführungsbeispiel der Erfindung.

Da die Spacer 301 anschaulich im Wesentlichen als Hilfsstützen für die Herstellung der zweiten Schichten 106 dienen und eine Bildung von möglichst großen Hohlräumen 109 zwischen den Leiterbahnen 104 behindern, werden die Spacer 301 nach der Herstellung der zweiten Schichten 106 wieder entfernt. Das Siliziumnitrid (Si₃N₄) der Spacer 301 wird dazu nach der Erzeugung der zweiten Schichten 106 weggeätzt, wobei ein selektiver, isotroper Ätzprozess zur Anwendung kommt. Der zwischen benachbarten Spacern 301 befindliche Luftspalt 302 ist dabei zur Entfernung der Spacer 301 notwendig, um dem Ätzmittel an den Spacern 301 eine Angriffsfläche zu bieten.

Zwischen den Seitenwänden 108 benachbarter Leiterbahnen 104, der ersten Schichtoberfläche 102 und den zweiten Schichten 106 befinden sich nun möglichst große Zwischenräume 502. Jeweils benachbarte zweite Schichten 106 bilden auf Grund ihres Abstandes zwischen sich Öffnungen 501 für die Zwischenräume 502, wodurch die Zwischenräume 502 nicht vollständig abgeschlossen sind.

Zur Bildung von Hohlräumen 109 aus den Zwischenräumen 502 müssen nun die Öffnungen 501 geschlossen werden. Deshalb erfolgt die Erzeugung der dritten Schicht 107 in zwei separaten Verfahrensschritten. Zunächst wird Siliziumdioxid (SiO₂) mittels eines nicht-konformen Verfahrens über den zweiten Schichten 106 abgeschieden, bis die Öffnungen 501 geschlossen sind und sich Hohlräume 109 zwischen der ersten Schicht 101, den benachbarten Leiterbahnen 104, den zweiten Schichten 106 und der dritten Schicht 107 gebildet haben. Anschließend wird Siliziumdioxid (SiO₂) mittels eines konformen Standardverfahrens zur Bildung einer dicken isolierenden dritten Schicht 107 abgeschieden, wie in Fig.1 dargestellt ist.

Während des nicht-konformen Verfahrens dringt wegen der schirmartig wirkenden zweiten Schichten 106 kaum Siliziumdioxid (SiO₂) in die entstehenden Hohlräume 109 ein. Dadurch kommt es zu einer nur sehr geringen Bedeckung 110 der Seitenwände 108 der Leiterbahnen 104 mit Siliziumdioxid (SiO₂), wodurch die relative Dielektrizitätskonstante εᵣ der gesamten Leiterbahnanordnung 100 nur unwesentlich beeinflusst wird.

Die Leiterbahnanordnung 100, und somit auch eine letzte Leiterbahn 104 ohne benachbarte Leiterbahn 104 neben einer ihrer beiden Seitenwände 108, benötigt eine elektrische Isolierung gegenüber der Umgebung. Deshalb wird die dritte Schicht 107 über der gesamten Leiterbahnanordnung 100 gebildet. Da die letzte Leiterbahn 104 nur noch neben einer ihrer beiden Seitenwände 108 eine benachbarte Leiterbahn 104 aufweist, wird die letzte Leiterbahn 104 nicht mehr mittels eines Hohlraums 109 wie zwischen benachbarten Leiterbahnen 104 sondern mittels eines Abschlusshohlraums 111 und einer Abschlussisolationsschicht 112 elektrisch isoliert. Dabei entsteht die Abschlussisolationsschicht 112 als Nebeneffekt während der Erzeugung der dritten Schicht 107 und weist somit ebenfalls Siliziumdioxid (SiO₂) auf.

In **Fig.6** ist ein Querschnitt durch eine noch nicht fertiggestellte Leiterbahnanordnung 600 zu einem ersten Zeitpunkt während der Durchführung des Herstellungsverfahrens gemäß einem zweiten Ausführungsbeispiel der Erfindung gezeigt.

Die noch nicht fertiggestellte Leiterbahnanordnung 600 des zweiten Ausführungsbeispiels unterscheidet sich von der noch nicht fertiggestellten Leiterbahnanordnung 200 des ersten Ausführungsbeispiels nur in der unterschiedlichen Struktur der ersten Schicht 101.

Die erste Schicht 101 weist gemäß diesem Ausführungsbeispiel eine obere Teilschicht 601 aus Siliziumdioxid (SiO₂), eine Ätzstoppschicht 602 aus Siliziumnitrid (Si₃N₄) und eine untere Teilschicht 603 aus Siliziumdioxid (SiO₂) auf. Die erste Schicht 101 kann jedoch auch aus Schichten mit anderen Isolationsmaterialien zusammengesetzt sein. Werden für die obere Teilschicht 601 und die untere Teilschicht 603 verschiedene Isolationsmaterialien mit unterschiedlichem Verhalten bei einem Ätzprozess verwendet, kann auf die Ätzstoppschicht 602 verzichtet werden.

Die obere Teilschicht 601 ist derart strukturiert, dass sie unter den Leiterbahnen 104 angeordnet ist und unter den Bereichen zwischen der Leiterbahnen 104 fehlt. In der oberen Teilschicht 601 befinden sich Gräben 604, welche mit gleichbleibender Breite zwischen den Leiterbahnen 104 von der zweiten Schichtoberfläche 105 bis zur Ätzstoppschicht 602 hinabreichen.

Die Strukturierung der oberen Teilschicht 601 kann folgendermaßen erfolgen: Zunächst wird das Siliziumdioxid (SiO₂) für die obere Teilschicht 601 flächig abgeschieden. Danach werden die Leiterbahnen 104, wie bereits in der Beschreibung zu Fig.2 erläutert, hergestellt. Anschließend werden die Gräben 604 in das flächig abgeschiedene Isolationsmaterial geätzt, wobei die Leiterbahnen als Ätzmaske verwendet werden. Dabei kann beispielsweise ein nasschemischer Downstream-Ätzprozess zur Anwendung kommen. Bei der Auswahl des anzuwendenden Ätzprozesses sollte darauf geachtet werden, dass das Ätzmittel bevorzugt auf das Siliziumdioxid (SiO₂) und nicht auf das Leiterbahnmaterial einwirkt. Der Ätzprozess wird beendet, sobald die Ätzstoppschicht 602 freigelegt ist.

Gemäß diesem Ausführungsbeispiel weisen die Gräben 604 eine Tiefe auf, welche bevorzugt der 0,5-fachen bis 2-fachen Breite der Leiterbahnen 104 entspricht.

Die weiteren Herstellungsschritte für eine Leiterbahnanordnung gemäß dem zweiten Ausführungsbeispiel entsprechen den oben für das erste Ausführungsbeispiel beschriebenen Herstellungsschritten. Die Leiterbahnanordnung gemäß dem zweiten Ausführungsbeispiel entspricht somit im Wesentlichen der Leiterbahnanordnung 100 gemäß dem ersten Ausführungsbeispiel. Die beiden Ausführungsbeispiele unterscheiden sich lediglich im Aufbau der ersten Schicht 101. Somit weisen die Hohlräume 109 in dem zweiten Ausführungsbeispiel, verglichen mit dem ersten Ausführungsbeispiel, wegen der Existenz der Gräben 604 ein größeres Volumen auf.

Für die Bildung einer erfindungsgemäßen Leiterbahnanordnung gemäß dem ersten oder zweiten Ausführungsbeispiel können statt der gewählten Isolationsmaterialien sowie deren Herstellungsprozesse auch andere isolierende Materialien und Herstellungsprozesse verwendet werden.

Beispielsweise sind als drittes Isolationsmaterial für die dritte Schicht 107 isolierende low-k-Materialien mit einer niedrigen relativen Dielektrizitätskonstante εᵣ geeignet, welche in einem Spin-on-Prozess aufgebracht werden und eine geringe Viskosität aufweisen. In einem Spin-on-Prozess wird das aufzubringende, meist flüssige Material während einer Schleuderbeschichtung mittels Aufschleudern auf die zu beschichtenden Flächen aufgebracht.

Wenn als drittes Isolationsmaterial ein low-k-Material mit hoher Viskosität verwendet wird und dadurch kein drittes Isolationsmaterial durch die Öffnungen 501 in die Zwischenräume 502 eindringt, folglich also keine Bedeckung 110 entsteht, kann das low-k-Material direkt zum Abschluss der Hohlräume 109 und somit zur Bildung der dritten Schicht 107 verwendet werden. Andernfalls wird zunächst Siliziumdioxid (SiO₂) zum Abschluss der Hohlräume 109 nichtkonform über den Öffnungen 501 und erst danach das low-k-Material als dritte Schicht 107 abgeschieden.

In diesem Dokument sind folgende Veröffentlichungen zitiert:
[1] B. Shieh et al., Solid State Technology, p. 51-58, February 1999
[2] J.G. Fleming et al.. Conference Proceedings ULSI XII. Materials Research Society, p. 471-477, 1997
[3] T. Ueda et al., IEEE Proc. 1998 Symp. VLSI Techn. Digest of Technical Papers, p. 46-47, 1998
[4] JP 10 116903 A
[5] US 6 130 151 A
[6] EP 0 687 004 A1
[7] US 5 759 913 A
[8] T. Kusuki et al., Extended Abstracts of the Electrochemical Society, Vol. 93-1, p. 375, 1993
[9] S. Suto et al., Proceedings of the Electrochemical Society, Vol. 88-7, p. 86-94, 1988

### Bezugszeichenliste

- 100: Leiterbahnanordnung gemäß erstem Ausführungsbeispiel
- 101: erste Schicht
- 102: erste Schichtoberfläche
- 103: Zwischenschicht
- 104: Leiterbahn
- 105: zweite Schichtoberfläche
- 106: zweite Schicht
- 107: dritte Schicht
- 108: Seitenwand
- 109: Hohlraum
- 110: Bedeckung
- 111: Abschlusshohlraum
- 112: Abschlussisolationsschicht
- 200: noch nicht fertiggestellte Leiterbahnanordnung gemäß erstem Ausführungsbeispiel zu einem ersten Herstellungszeitpunkt
- 300: noch nicht fertiggestellte Leiterbahnanordnung gemäß erstem Ausführungsbeispiel zu einem zweiten Herstellungszeitpunkt
- 301: Spacer
- 302: Luftspalt
- 400: noch nicht fertiggestellte Leiterbahnanordnung gemäß erstem Ausführungsbeispiel zu einem dritten Herstellungszeitpunkt
- 500: noch nicht fertiggestellte Leiterbahnanordnung gemäß erstem Ausführungsbeispiel zu einem vierten Herstellungszeitpunkt
- 501: Öffnung
- 502: Zwischenraum
- 600: noch nicht fertiggestellte Leiterbahnanordnung gemäß zweitem Ausführungsbeispiel zu einem ersten Herstellungszeitpunkt
- 601: obere Teilschicht
- 602: Ätzstoppschicht
- 603: untere Teilschicht
- 604: Graben

## Patentansprüche

1. verfahren zur Herstellung einer Leiterbahnanordnung (100) auf einer integrierten Schaltungsanordnung,
• bei dem auf einer ersten Schichtoberfläche (102) einer ersten Schicht (101) mindestens zwei Leiterbahnen (104) aufgebracht werden, wobei die Leiterbahnen (104) eine der ersten Schichtoberfläche (102) im Wesentlichen parallele zweite Schichtoberfläche (105) und zwischen der ersten Schichtoberfläche (102) und der zweiten Schichtoberfläche (105) befindliche Seitenwände (108) sowie ein elektrisch leitfähiges erstes Material und die erste Schicht (101) ein erstes Isolationsmaterial aufweisen,
• bei dem an den Seitenwänden (108) der Leiterbahnen Spacer (301) aus Spacermaterial erzeugt werden, indem das Spacermaterial über der ersten Schicht (101) und den Leiterbahnen (104) zunächst konform abgeschieden und dann parallel zur ersten Schichtoberfläche (102) derart selektiv und anisotrop geätzt wird, dass sich die Spacer (301) von benachbarten Leiterbahnen (104) nicht berühren,
• bei dem je Leiterbahn (104) eine zweite Schicht (106) aus einem zweiten Isolationsmaterial auf der zweiten Schichtoberfläche (105) und den Spacern (301) erzeugt wird, wobei jede zweite Schicht (106) derart angeordnet ist, dass die zweite Schicht (106) über die Leiterbahn übersteht und benachbarte zweites Schichten (106) noch nicht berührt werden, und
• bei dem über den zweiten Schichten (106) eine dritte Schicht (107) aus einem dritten Isolationsmaterial erzeugt wird, wodurch zwischen der ersten Schicht (101), den benachbarten Leiterbahnen (104), den zweiten Schichten (106) und der dritten Schicht (107) eine Leiterbahnanordnung (100) gebildet wird.

2. Verfahren gemäß Anspruch 1,
bei dem vor dem Aufbringen der Leiterbahnen auf der ersten Schichtoberfläche mindestens eine Zwischenschicht (103) aus einem zweiten Material auf der ersten Schichtoberfläche (102) erzeugt wird.

3. Verfahren gemäß Anspruch 1 oder 2,
bei dem zwischen benachbarten Leiterbahnen (104) Gräben erzeugt werden, welche zumindest teilweise in die erste Schicht (101) hineinreichen.

4. Verfahren gemäß Anspruch 3,
bei dem die erste Schicht (101) aus einer oberen Teilschicht (601), einer Ätzstoppschicht (602) und einer unteren Teilschicht (603) erzeugt wird und bei dem die Gräben zwischen benachbarten Leiterbahnen (104) dadurch erzeugt werden, dass mittels der Leiterbahnen als Maske die obere Teilschicht (601) unter den Bereichen zwischen benachbarten Leiterbahnen entfernt und die Ätzstoppschicht (602) freigelegt wird.

5. Verfahren gemäß einem der Ansprüche 1 bis 4,
bei dem die Spacer (301) unter den zweiten Schichten wieder entfernt werden.

6. Verfahren gemäß einem der Ansprüche 1 bis 5,
bei dem die zweiten Schichten (106) mittels eines nicht-konformen Verfahrens im Wesentlichen parallel zur ersten Schichtoberfläche über der zweiten Schichtoberfläche (105) und den Spacern (301) erzeugt werden.

7. Verfahren gemäß einem der Ansprüche 1 bis 6,
bei dem das Spacermaterial der Spacer (301) nach der Erzeugung der zweiten Schichten (106) weggeätzt wird, wobei ein selektiver Ätzprozess zur Anwendung kommt.

8. Verfahren gemäß Anspruch 7,
bei dem der selektive Ätzprozess isotrop ist.

9. Verfahren gemäß einem der Ansprüche 1 bis 8,
bei dem die Erzeugung der dritten Schicht (107), derart erfolgt, dass zunächst drittes Isolationsmaterial mittels eines nicht-konformen Verfahrens über den zweiten Schichten (106) abgeschieden wird, bis sich Hohlräume zwischen der ersten Schicht, den benachbarten Leiterbahnen (104), den zweiten Schichten (106) und der dritten Schicht (107) gebildet haben, und anschließend drittes Isolationsmaterial mittels eines konformen Standardverfahrens abgeschieden wird.

## Claims

1. Method for fabricating an interconnect arrangement (100) on an integrated circuit arrangement,
• in which at least two interconnects (104) are applied on a first layer surface (102) of a first layer (101), the interconnects (104) having a second layer surface (105) essentially parallel to the first layer surface (102) and sidewalls (108) situated between the first layer surface (102) and the second layer surface (105) and also an electrically conductive first material and the first layer (101) having a first insulation material,
• in which spacers (301) made of spacer material are produced on the sidewalls (108) of the interconnects, by firstly depositing the spacer material conformally above the first layer (101) and the interconnects (104) and then etching selectively and anisotropically parallel to the first layer surface (102) in such a way that the spacers (301) of adjacent interconnects (104) do not touch one another,
• in which, for each interconnect (104), a second layer (106) made of a second insulation material is produced on the second layer surface (105) and the spacers (301), each second layer (106) being arranged in such a way that the second layer (106) projects beyond the interconnect and adjacent second layers (106) are still not touched, and
• in which a third layer (107) made of a third insulation material is produced above the second layers (106), as a result of which an interconnect arrangement (100) is formed between the first layer (101), the adjacent interconnects (104), the second layers (106) and the third layer (107).

2. Method according to Claim 1,
in which, before the application of the interconnects on the first layer surface, at least one intermediate layer (103) made of a second material is produced on the first layer surface (102).

3. Method according to Claim 1 or 2,
in which trenches which reach at least partly into the first layer (101) are produced between adjacent interconnects (104).

4. Method according to Claim 3,
in which the first layer (101) is produced from an upper partial layer (601), an etching stop layer (602) and a lower partial layer (603), and in which the trenches are produced between adjacent interconnects (104) by the fact that, using the interconnects as mask, the upper partial layer (601) is removed below the regions between adjacent interconnects and the etching stop layer (602) is uncovered.

5. Method according to one of Claims 1 to 4,
in which the spacers (301) are removed again below the second layers.

6. Method according to one of Claims 1 to 5,
in which the second layers (106) are produced by means of a non-conformal method essentially parallel to the first layer surface above the second layer surface (105) and the spacers (301).

7. Method according to one of Claims 1 to 6,
in which the spacer material of the spacers (301) is etched away after the production of the second layers (106), a selective etching process being employed.

8. Method according to Claim 7,
in which the selective etching process is isotropic.

9. Method according to one of Claims 1 to 8,
in which the production of the third layer (107) is effected in such a way that firstly third insulation material is deposited by means of a non-conformal method over the second layers (106) until cavities have formed between the first layer, the adjacent interconnects (104), the second layers (106) and the third layer (107), and third insulation material is subsequently deposited by means of a conformal standard method.

## Revendications

1. Procédé de production d'un système (100) de pistes conductrices sur un circuit intégré,
• dans lequel on dépose au moins deux pistes (104) conductrices sur une première surface (102) de couche d'une première couche (101), les pistes (104) conductrices ayant une deuxième surface (105) de couche sensiblement parallèle à la première surface (102) de couche et des parois (108) latérales se trouvant entre la première surface (102) de couche et la deuxième surface (105) de couche ainsi qu'un premier matériau conducteur de l'électricité et la première couche (101) ayant un premier matériau isolant ;
• dans lequel on produit, sur les parois (108) latérales des pistes conductrices, des espaceurs (301) en matériau d'espaceur, en déposant d'abord de manière conforme le matériau d'espaceur sur la première couche (101) et sur les pistes (104) conductrices, puis en l'attaquant de façon sélective et anisotrope parallèlement à la première surface (102) de couche de façon à ne pas toucher des espaceurs (301) de pistes conductrices voisines ;
• dans lequel on produit pour chaque piste (104) conductrice une deuxième couche (106) en un deuxième matériau isolant sur la deuxième surface (105) de couche et sur les espaceurs (301), chaque deuxième couche (106) étant disposée de manière à ce que la deuxième couche (106) dépasse de la piste conductrice et ne touche pas encore des deuxièmes couches (106) voisines ; et
• dans lequel on produit au-dessus de la deuxième couche (106) une troisième couche (107) en un troisième matériau isolant de manière à former un système (100) de pistes conductrices entre la première couche (101), les pistes (104) conductrices voisines, la deuxième couche (106) et la troisième couche (107).

2. Procédé suivant la revendication 1, dans lequel, avant le dépôt des pistes conductrices sur la première surface de couche, on produit au moins une couche (103) intermédiaire en un deuxième matériau sur la première surface (102) de couche.

3. Procédé suivant la revendication 1 ou 2, dans lequel on produit entre des pistes (104) conductrices voisines des sillons qui vont au moins en partie dans la première couche (101).

4. Procédé suivant la revendication 3, dans lequel on produit la première couche (101) en la constituant d'une sous-couche (601) supérieure, d'une couche (602) d'arrêt d'attaque et d'une sous-couche (603) inférieure et dans lequel on produit les sillons entre des pistes (104) conductrices voisines en éliminant au moyen des pistes conductrices servant de masque la sous-couche (601) supérieure en dessous des régions entre des pistes conductrices voisines et en mettant à nu la couche (602) d'arrêt d'attaque.

5. Procédé suivant l'une des revendications 1 à 4, dans lequel on élimine à nouveau les espaceurs (301) en dessous des deuxièmes couches.

6. Procédé suivant l'une des revendications 1 à 5, dans lequel on produit les deuxièmes couches (106) au moyen d'un procédé non conforme sensiblement parallèlement à la première surface de couche au-dessus de la deuxième surface (105) de couche et des espaceurs (301).

7. Procédé suivant l'une des revendications 1 à 6, dans lequel on élimine par attaque le matériau des espaceurs (301) après la production des deuxièmes couches (106) en utilisant une opération d'attaque sélective.

8. Procédé suivant la revendication 7, dans lequel l'opération d'attaque sélective est isotrope.

9. Procédé suivant l'une des revendications 1 à 8, dans lequel on effectue la production de la troisième couche (107) en déposant d'abord du troisième matériau isolant au moyen d'un procédé non conforme sur les deuxièmes couches (106) jusqu'à former des cavités entre la première couche, les pistes (104) conductrices voisines, les deuxièmes couches (106) et la troisième couche (107) et on dépose ensuite du troisième matériau isolant au moyen d'un procédé conforme standard.
